Europäisches Patentamt

European Patent Office

Office européen des brevets

(19)

(11) Publication number:

**0 201 106**
**A2**

(12) **EUROPEAN PATENT APPLICATION**

(21) Application number: 86106353.5

(22) Date of filing: 09.05.86

(51) Int. Cl.⁴: **H 03 M 1/24**

(30) Priority: 10.05.85 US 732549

(43) Date of publication of application: 12.11.86
Bulletin 86/46

(84) Designated Contracting States: DE FR GB

(71) Applicant: Hewlett-Packard Company, Mail
Stop 20 B-O 3000 Hanover Street, Palo Alto
California 94304 (US)

(72) Inventor: Gordon, Gary, 21112 Bankmill Road, Saratoga,
CA.95070 (US)
Inventor: Keith, Williamson, 2230 Homestead Court,
Apt. 104, Los Altos CA.94022 (US)
Inventor: Andrews, Randy, 1034 Colorado, Apt. 1B, Palo
Alto, CA-94303 (US)

(74) Representative: Liesegang, Roland, Dr.-Ing.,
Sckellstrasse 1, D-8000 München 80 (DE)

(54) **Absolute Position encoder.**

(57) A digital position encoder for determining the absolute
position of a servo-controlled mechanism such as a robot
joint comprises an incremental encoder (32) and a discrete
encoder (34). The incremental encoder (32) produces puls-
es indicating the incremental rotation of the motor drive
shaft (24) for the joint and an index pulse once each rotation
of the shaft. The discrete encoder (34) comprises a set of
precessing gears (42, 44, 46) driven by the motor shaft (24),
each of which produces a mark pulse once each rotation.
The angular displacements of the precessing gears with
respect to the index pulse are measured, using signals from
the incremental encoder (32), thus determining a unique
motor revolution positon in the range of motor revolutions
which span the range of motion of the servo-controlled
member. The motor revolution position and the incremental
position are combined mathematically to yield the absolute
position of the servo-controlled member.

ABSOLUTE POSITION ENCODER

Robots and other servo-controlled positioning mechanisms require position transducers as part of their servo loops. Generally, an actuator and a position transducer are associated with each robot joint. Often, for performance, economy and compatibility with all-digital computer control systems, the transducers are of the incremental type, and measure only relative rather than absolute position. However, some method of determining the absolute position of the mechanism is desirable and is generally incorporated as an additional element, involving considerable additional expense and complexity.

An important procedure in robot control is initialization -- determining the position of the robot mechanism when it is first turned on. When first energized, the position of the robot joints may be completely unknown. In this condition, relative position information is not adequate to define the position of the mechanism. In order to define a reference point and to orient the robot mechanism with respect to its operating environment, additional information concerning the absolute position of the mechanism is required.

Typically, digital incremental encoders are mounted on the drive shaft of the motor which drives the joint. Such encoders generate a series of pulses which resolve the rotation of the drive shaft into a number of small segments, and also generate an index pulse once each shaft revolution. Thus these encoders can

1

provide information about the relative motion of the drive shaft and the robot arm, and about the position of the drive shaft on a particular revolution, but cannot provide information about the absolute position of the robot arm.

One approach to determining the absolute position of a mechanism is to establish a zero or home position for each of the joint actuators in the mechanism and to initialize the actuators by moving them to their home positions whenever the mechanism is turned on. Thereafter, the movement of the mechanism can be tracked from this starting point using the relative position information from the incremental encoders. The disadvantage with this approach is that the mechanism must be moved from its starting position to the zero position to initiate the process. Conceivably, zero could be found by slowly moving the joints in one directon until an optical switch or other end-sensing device is reached, but this might cause the mechanism to hit an obstruction, especially in the case of a robot having multiple joints, each with an unknown orientation.

Another technique is to add an analog encoding device, for example, a potentiometer or a capacitive encoder at the output side of each joint, in addition to the incremental digital encoders at the input side. The analog encoder must have sufficient accuracy to determine the absolute position of the joint to within the range of the digital encoder, which is typically one revolution of the drive motor. Thus, if the motor drives the joint through 100:1 reduction gearing, the range of the digital encoder would be 3.6 degrees (i.e., 360/100), and the

analog encoder must be able to determine the position of the joint to within 3.6 degrees, or one motor revolution. Then the digital incremental encoder can be used to determine the position within that one revolution, 3.6 degree, sector, and thus complete the determination of the absolute position of the joint. The disadvantage of this approach is that it requires additional encoders and their associated circuitry at each joint. This is particularly expensive in the case of encoders which require analog circuitry. Furthermore, analog devices are more difficult to calibrate and their operation may be adversely affected by environmental conditions such as temperature variations and electromagnetic noise, making them less reliable in typical industrial settings.

A further alternative is to add to the output of each joint a digital encoder, such as a Gray-scale encoder, which is capable of resolving the absolute position of the joint. Generally, such precision devices are relatively expensive and bulky, increasing to the overall cost and complexity of the system.

Another disadvantage of devices which monitor the output position is that they are limited to joint motion of less than one revolution. Such a device could not provide unambiguous position information for a mechanism which undergoes a wider range of movement, for example a wrist joint capable of rotating one revolution in either direction from its starting position.

An object of the present invention is to provide a totally digital position encoder system which can determine the absolute position of a mechanism such as a servo controlled actuator for a joint or a linear axis device, using only a small motion of the actuator at the time of start up.

Another object of the invention is to provide a digital position encoder which can determine the absolute position of the output of a mechanism driven through a reduction drive by using sensors mounted on the input side of the reduction drive.

These and other objects are accomplished by the features of claim 1.

In the illustrated preferred embodiment of the present invention, absolute position information is provided in a compact, motor mounted module by adding an inexpensive digital discrete encoder to an incremental encoder and using the combination of signals from the incremental encoder and the digital discrete encoder to determine the absolute position of the mechanism.

The incremental encoder produces pulses indicating the incremental rotation of the motor drive shaft for the actuator and an index pulse once each rotation of the shaft. The digital discrete encoder is contained in a compact housing which can be easily mounted on the end of the incremental encoder. The discrete encoder comprises a set of precessing gears driven by the motor shaft, each of which produces a mark pulse once each rotation. The angular displacement of the precessing gears with respect to the index pulse is measured, determining a unique motor revolution position in the range of motor revolutions which span the range of motion of the servo-controlled member. The motor revolution position and the incremental position are combined mathematically to yield the absolute position of the servo-controlled mechanism.

Using the combination of incremental and discrete encoders of the present invention, the intialization command can be carried out with a minimum range of motion by the robot joint. By moving the joint less than one motor revolution in each direction the absolute position of the joint can be determined. This minimizes the time required for initialization and also minimizes the chance that the robot arm will hit an obstruction during the initialization procedure.

It will be understood that although the preferred embodiment of the invention is described in the context of robotics, the invention may be used to determine the absolute position of any mechamism driven by a motor actuator, whether the subsequent output is rotary or linear. Such actuators are used in a wide variety of applications in addition to robotics, including for example, machine tools, plotters, printers, copy machines and other office equipment; aircraft, missiles, satellites and antennas; valves and other process control equipment.

Figure 1 illustrates an actuator for a robot joint driven by a servomotor and including a position encoder constructed according to the preferred embodiment of the present invention.

Figure 2 is a schematic view of the discrete encoder shown in Figure 1.

Figure 3 is a schematic block diagram of the circuitry associated with the actuator system including the position encoder shown in Figure 1.

Figure 4 is a schematic view of an alternative embodiment of the invention.

Figure 5 is a graphic representation of the travel of a robot joint expressed in terms of revolutions of the drive motor.

Figure 6 is a more detailed illustration of a portion of the graph depicted in Figure 5.

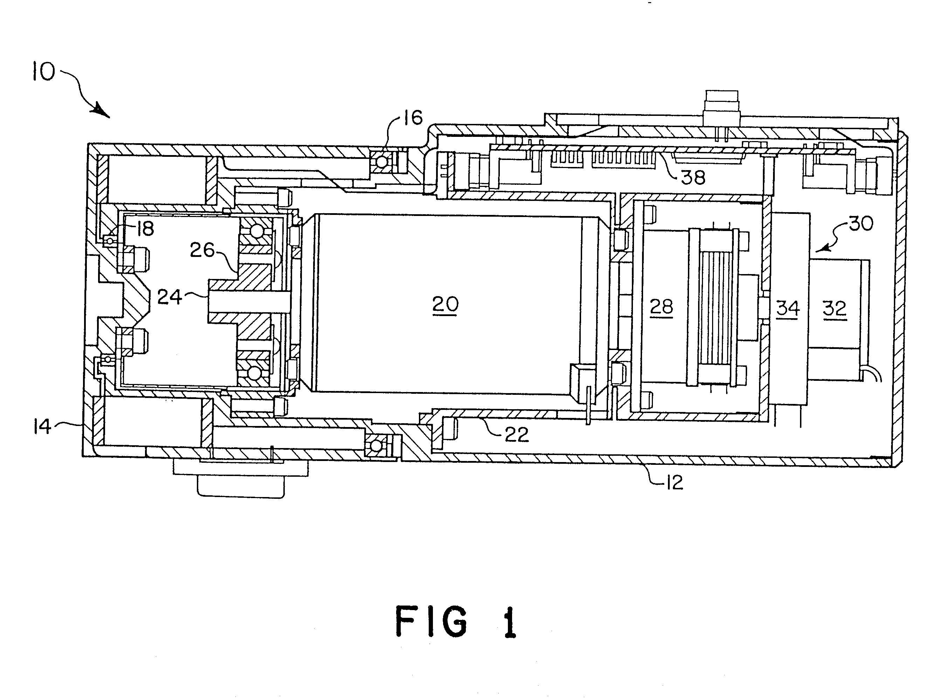

The preferred embodiment of the present invention as incorporated in a servo motor drive module 10 for a robot joint is illustrated in Figure 1. The module comprises a two-section housing which encloses a servo drive motor, a gear reducer, a brake and the position encoder of the invention. In the preferred embodiment, a circuit board holding a microprocessor and other circuitry required to operate the servo motor in response to commands received from the central controller is also mounted within the housing.

The preferred embodiment will be understood to operate within the context of a robot system of the type which may be controlled by a computer controller to manipulate an arm which has multiple articulated segments. A microprocessor is incorporated for receiving and transmitting signals to the computer controller, and for performing the computations required to carry out the position sensing and motor drive functions involved in responding to the signals from the computer controller.

Those skilled in the art of robot operation will readily understand that any number of computer configurations can be used to operate the apparatus of the invention. When the term "controller" is used in this application, it refers to whatever control apparatus is appropriate to the chosen configuration, whether it is a relatively large mainframe computer or a more specialized computer control system developed for a particular robot system.

Module 10 comprises a fixed housing 12 which is mounted on the input side of the robot joint and a movable housing 14 to which is attached the output side of the robot joint. Housing 14 is connected to housing 12 through bearings 16 and 18, so that the two housings can rotate freely with respect to each other. Thus, if module 10 were used to operate an elbow joint, housing 12 would be mounted on the upper arm and the lower arm would be attached to housing 14. Mounted within module 10, and fixedly connected to housing 12 by a mounting sleeve 22 is servo drive motor 20. Any suitable servo motor, for example, a Pittman model 13203 motor, may be used. One end of motor drive shaft 24 is connected to movable housing 14 through a gear reducer 26. A harmonic gear reducer, for example the HDC-3C model made by Emhart, is well suited for robotics because it is compact, provides a relatively high ratio speed reduction, e.g., 120:1, and produces smooth operation and sufficient torque for moving the robot joint. The other end of shaft 24 is connected to brake 28 and to position encoder 30.

Position encoder 30 comprises an incremental position encoder 32 and a discrete position encoder 34, both driven by the rotation of shaft 24. Incremental encoder 32 is a rotating disc optical encoder of the type described in U.S. patent 4,266,125, for example. Encoder 32 produces two types of output signals: a series of pulses which indicate the relative incremental rotation of the shaft, and an index pulse once each revolution when the shaft rotates past an index position. Typically, the incremental encoder 32 has two output channels which produce 1000 pulses per revolution with the pulses of one channel shifted 90 degrees from those of the second channel. After decoding, these outputs can divide each shaft rotation into 4000 incremental segments and indicate the direction of shaft rotation.

Discrete encoder 34 produces index pulses from each of two gears which precess with respect to the rotation of the motor drive shaft, as described in more detail below. From the pattern of index pulses produced by discrete encoder 34, the position of the joint can be determined to within one revolution of the drive shaft, as described below.

Also mounted within module 10 is circuit board 38 which holds a microprocessor, a motor driver, logic to decode signals from the incremental encoder, and other circuitry associated with the operation of the servo control module. By this arrangement, the majority of the signal processing required to operate the joint control module can be done within the module itself. This greatly simplifies the central control system and minimizes the information communicated from the joint to the central control system as well as the wiring used for such communication. This provides for a much less cumbersome robot design.

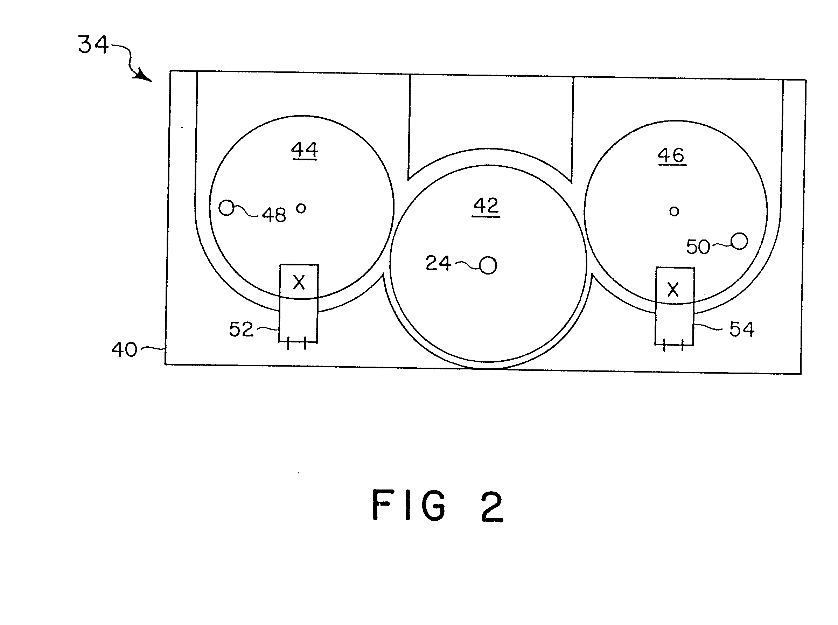

The construction and components of discrete encoder 34 are shown in more detail in Figure 2. Encoder 34 comprises a housing 40 holding three gears 42, 44 and 46. Gear 42, the center gear, has T1 teeth and is connected to motor drive shaft 24 for rotation with that shaft. Gear 42 drives first idler gear 44 having T2 teeth and second idler gear 46 having T3 teeth. Idler gears 44 and 46 have apertures 48 and 50 near their periphery. Also mounted on housing 40 are photodetectors 52 and 54, positioned over the periphery of gears 44 and 46 along the path of apertures 48 and 50 so that they can detect the passage of apertures 48 and 50 on each revolution of gears 44 and 46.

The three gears 42, 44 and 46 have different numbers of teeth so that their rotations precess with respect to one another. One combination of tooth numbers which has been found to be particularly advantageous is 17, 16 and 15 teeth for gears 42, 44 and 46 respectively. Using this combination, for every revolution of gear 42, gear 44 rotates 17/16 of a revolution and gear 46 rotates 17/15 of a revolution. Thus, if the three gears start in alignment (i.e., coincident index pulses from photodetectors 52 and 54 and from encoder 32), gears 42 and 44 will not again be in alignment until after 16 revolutions of gear 42, gears 42 and 46 will not again be in alignment until after 15 revolutions of gear 42, and all three gears will not again be in alignment until after 240 revolutions (15 x 16) of gear 42. Furthermore, at the index pulse for each of the 240 revolutions of the drive gear, hence the motor shaft, there is a unique combination of angular positions of apertures 48 and 50 with respect to photodetectors 52 and 54. If the motor is connected to the joint actuator output through a 120:1 gear reduction, this provides a method of uniquely determining at which motor revolution the joint is positioned over 240 motor revolutions or two complete rotations of the joint.

It will be appreciated that many combinations of tooth numbers could be chosen, to yield different ranges of motor revolutions or to suit the particular needs of the designer. The choices are limited by the physical dimensions of the module into which the gears must fit and by the manufacturing limits to the number of teeth which can be put on gears of that size. It should be noted that for a combination of gears having tooth numbers with common factors, the range will be reduced by dividing the product of the tooth numbers by the product of the common factors. For example, a set of gears with 30, 32 and 34 teeth has a range of (30 x 32)/(2 x 2) = 240 revolutions, the same range as the set of gears with 15, 16 and 17 teeth in the example discussed earlier.

Another way to determine the range produced by a set of gears is to consider the number of "logical teeth" in each meshing pair of gears. The number of a gear's logical teeth is the number of physical teeth divided by the common factors between the numbers of physical teeth for that gear and for the gear with which it meshes. Using the example of a 34 tooth drive gear meshing with 30 tooth and 32 tooth idler gears, the 30 tooth idler has 15 logical teeth (30/2) and the 32 tooth idler has 16 logical teeth (32/2). The range is the product of the logical tooth numbers, 15x16=240 revolutions.

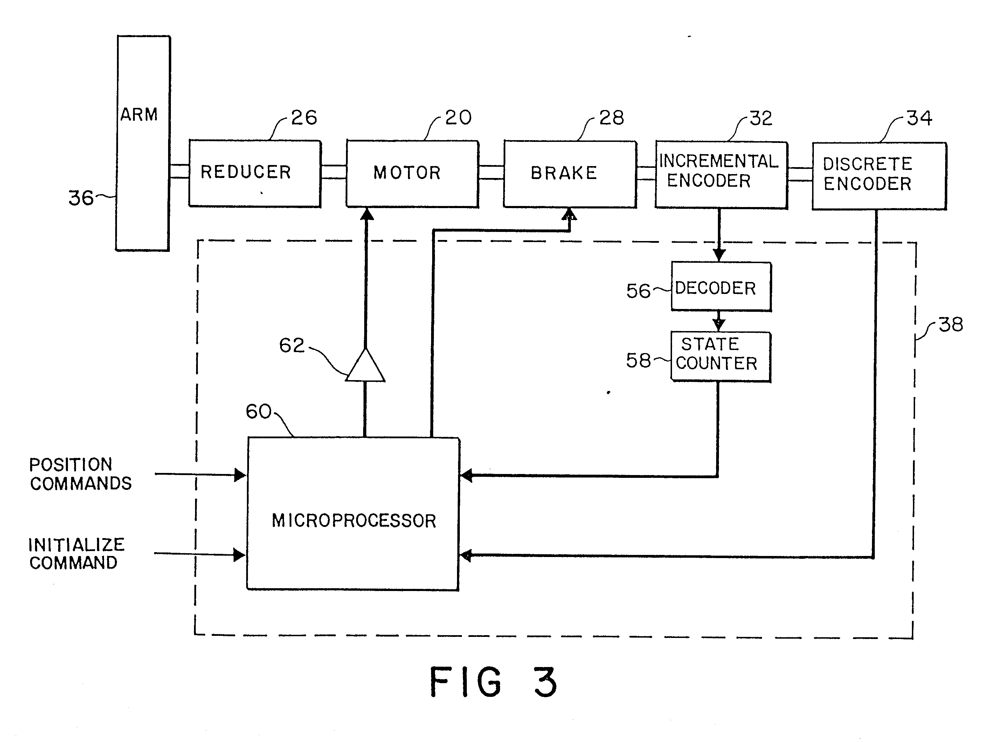

Figure 3 shows a schematic block diagram of a servo control actuator system including the position encoding apparatus of the present invention. The output shaft of motor 20 is physically connected through gear reducer 26 to movable robot arm 36. The output shaft of motor 20 is also physically connected to brake 28, to incremental encoder 32 and to discrete encoder 34. The electrical signals produced by incremental encoder 32 and discrete encoder 34 are sent to circuit board 38 (indicated by dashed line). The signals from the incremental encoder go to decoder logic 56 which determines which direction shaft 24 is rotating and also processes the signals to produce an output signal suitable for digital counting. The output of decoder logic 56 goes to state counter 58 which accumulates the digital counts to keep track of the state of the incremental encoder and outputs the result to microprocessor 60. The signals from the discrete encoder 34 are sent directly to microprocessor 60. In addition to the signals from the encoders, microprocessor 60 also receives commands from the central controller. The position command orders microprocessor 60 to move the robot joint to a certain position. The initialize command orders microprocessor 60 to determine the position of the robot joint. In order to carry out the commands it receives, microprocessor 60 transmits control signals to motor 20 through driver 62, and to brake 28.

Using the combination of incremental and discrete encoders of the present invention, the intialization command can be carried out with a minimum range of motion by the robot joint. By moving the joint less than one motor revolution in each

11

direction the absolute position of the joint can be determined. This minimizes the time required for initialization and also minimizes the chance that the robot arm will hit an obstruction during the initialization procedure.

Upon receiving the initialization command, microprocessor 60 directs motor 20 to rotate in a counterclockwise direction. The rotation is stopped a predetermined portion of a motor revolution past the first index pulse which microprocessor 60 receives from incremental encoder 32. Travel past the index position is desirable to remove any effect of gear backlash in the encoder from the position measurement. This procedure also simplifies the construction of the encoder by obviating the need for any mechanical means for eliminating backlash.

Microprocessor 60 then directs the motor to rotate in the clockwise direction. As the motor shaft rotates, microprocessor 60 records the position of the index pulse from encoder 32 and counts the number of incremental pulses between the index pulse and the position pulses (called "marks") received from photodetectors 52 and 54 of discrete encoder 34. When the microprocessor receives a second index pulse from incremental encoder 32, the motor is stopped. Because the drive gear 42 has a larger number of teeth than the two idler gears 44 and 46, it is assured that mark pulses from both photodetectors will occur between any two index pulses from incremental encoder 32.

The number of incremental pulses between the index pulse and each of the mark pulses represents an angular difference in position between the drive gear and the respective idler gears.

12

Each motor revolution in the range of 240 revolutions is represented by a unique combination of such angular differences. For example, in the configuration of the preferred embodiment, after one revolution from the "zero" position, idler gear 44 will be one tooth ahead of the drive gear and idler gear 46 will be two teeth ahead. After n revolution from zero, idler gear 44 will be n teeth ahead or n modulo 16 teeth apart from the index pulse. Likewise, after n revolutions, idler gear 46 will be 2n teeth ahead or 2n modulo 15 teeth apart from the index pulse. Since the microprocessor measures the angular separation directly, the motor revolution represented by the combination can be calculated or alternatively determined by comparing the measured values with predetermined values stored in a table in the memory of the microprocessor.

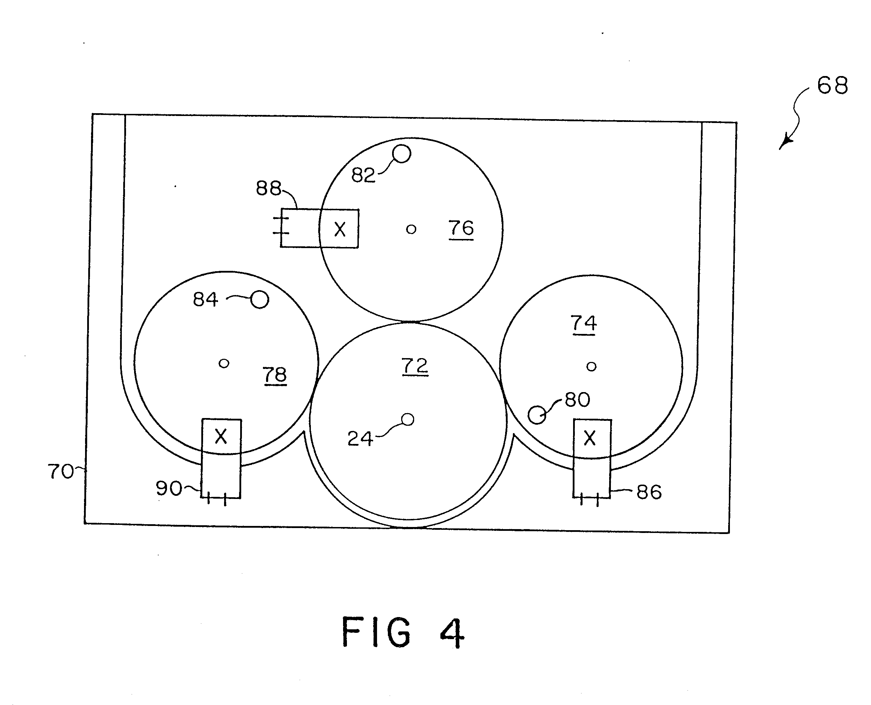

Figure 4 shows an alternate embodiment of the discrete encoder of the invention. In this embodiment, there are three rather than two idler gears, so that the range of motor revolutions which can be uniquely represented is significantly increased. Encoder 68 comprises a housing 70 which holds the drive gear 72 and the three idler gears 74, 76 and 78. As in the previous embodiment, drive gear 72 is connected to motor drive shaft 24 and drives the three idler gears. Idler gears 74, 76 and 78 have apertures 80, 82 and 84 near their periphery. Also as in the previous embodiment, there are photodetectors 86, 88 and 90 mounted on housing 70, positioned over each of the idler gears along the path of apertures 80, 82 and 84 so that they can detect the passage of the apertures on each revolution of idler gears 74, 76 and 78.

Again each of the gears have different numbers of teeth so that their rotations precess with respect to one another. Assuming that drive gear 72 has T1 teeth, idler gear 74 has T2 teeth, gear 76 has T3 teeth and gear 78 has T4 teeth, the four gear set provides a unique combination of angular positions of the three idler gears with respect to the drive gear for T2 x T3 x T4 motor revolutions, provided that T1, T2, T3 and T4 have no common factors. Thus the additional gear multiplies the range of motor revolutions which can be resolved by a factor equal to the number of logical teeth on the added gear. It can be seen that by adding more idler gears, the range of motor revolutions which an encoder can resolve can be expanded to suit the needs of the designer. Alternatively, the encoder can be built with only one idler gear if the number of logical teeth on that gear provides a sufficient range. Also, two or more discrete encoders may be stacked together with their outputs concatenated to further expand the range which can be resolved. Other methods may be used to link the encoder to the actuator, for instance components of harmonic gear reducer 26 could be used to drive the discrete encoder.

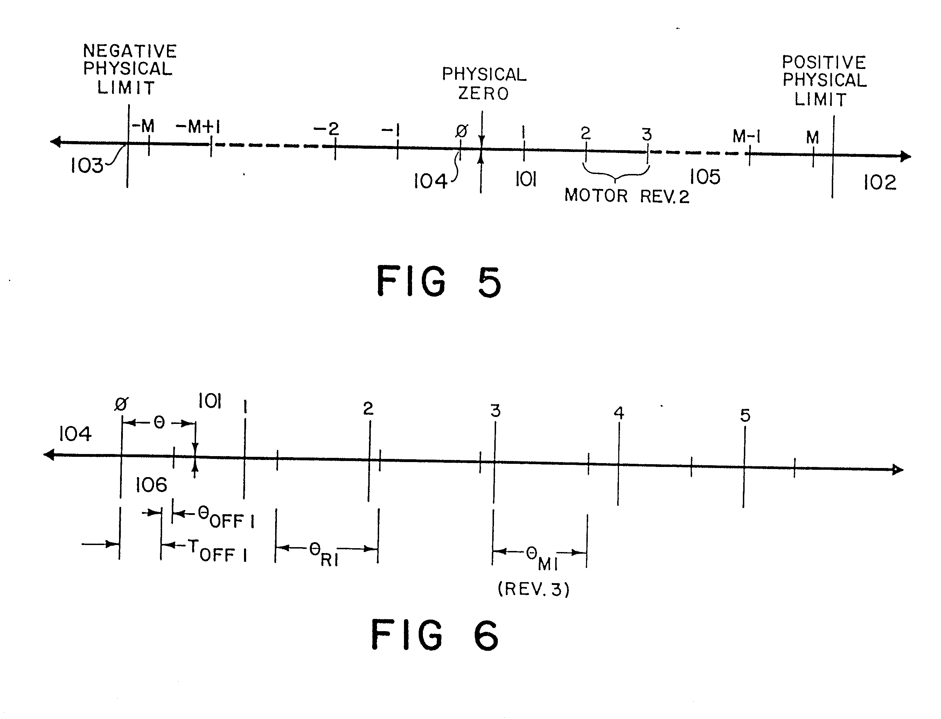

The operation of microprocessor 60 can be more easily understood by reference to Figures 5 and 6. Figure 5 is a graphic representation of the motor position space, showing the location of index pulses produced by the incremental encoder within that space.

The physical zero position 101 of the robot joint whose motion is represented in Figure 5 is the middle of the motor position space, with the positive physical limit 102 and the negative physical limit 103 at either end, establishing the physical range of motion of the joint. The index zero position 104, indicated as $\emptyset$, generally is not coincident with the physical zero position 101 due to the arbitrary position of the disc of the incremental encoder when the servo drive module is assembled with the robot arm. The index pulse used as index zero 104 is chosen so that physical zero 101 falls within the first positive motor revolution. From index zero 104, the motor space is divided by index pulses from incremental encoder 32 into a series of motor revolution segments 105 extending clockwise to the positive physical limit 102 and counterclockwise to the negative physical limit 103. For a motor space which extends n revolutions in the positive and negative direction, the gears of the discrete encoder should be chosen to provide a range greater than 2n.

Figure 6 shows a section of the motor space in more detail, including the mark pulses from one gear of the discrete encoder. The mark pulses from the second gear are omitted for clarity, and the following discussion applies equally to the index pulses from each gear. As in Figure 5, the physical zero 101 and index zero 104 are not coincident. The separation is designated $\theta z$, the zero offset. In addition, Figure 6 shows that the zero index pulse is not coincident with a discrete encoder mark pulse 106. This separation is designated in two parts, Toff1 which is an integral number of teeth and $\theta$off1 which is the fractional remainder. The fractional part ϑoffl is used as a calibration constant so that the position calculations can be done using the angular displacement of an integral tooth as the smallest division.

To locate the position of the robot joint within the motor space, microprocessor 60 first determines the angular displacement between the index pulse and the mark pulses. Then microprocessor 60 determines which motor revolution is associated with that combination of angular differences.

As described above, the angular displacement is determined by finding the next index pulse in the counterclockwise direction, then moving through one motor revolution and finding the two mark pulses. At the index pulse and at each mark pulse microprocessor 60 stores the output of incremental encoder state counter 58. The angular displacement of the first idler gear mark in incremental encoder counts is the difference between the stored values at the index pulse and the stored value at the first idler mark pulse. The result is adjusted by subtracting offset value ϑoffl, then expressed as a number of teeth by dividing by the number of incremental encoder counts per logical tooth and rounding to the nearest integral number. A similar procedure is followed to determine the angular displacement of the second idler gear.

The motor revolution associated with the two angular displacements remains to be determined. As described above, this can be accomplished by comparing the measured displacement values with the values stored in a table in memory until a match is found. Alternatively, the table of values can be generated and compared with the measured displacement values.

The absolute position of the robot joint can then be expressed in incremental encoder counts as:

Pos(absolute) = Rev x Res + [Pos(current)-Pos(index)-$\theta$z]

where,

Rev = current motor revolution in motor space

Res = incremental encoder counts/motor revolution

Pos(current) = current value on incremental encoder counter

Pos(index) = value on incremental encoder counter at first detected index pulse

$\theta$z = zero offset in incremental encoder counts

Microprocessor 60 can be adapted to perform the data processing for a wide variety of gear configurations. It can also make adjustments for a zero offset between the physical zero of the robot joint and the zero index pulse of the incremental encoder. This zero adjustment capability obviates the difficult task of aligning the optical disc of the incremental encoder when installing the motor drive module in the robot joint.

While the invention has been described in exemplary embodiment in a motor driven actuator, it will be appreciated that the encoder could also be used to determine the position of a mechanism whose output is moved manually rather than motor driven, for example, a robot system operated in a "learning mode".

Claims

1. A position encoder for determining the absolute position of mechanism, c h a r a c t e r i z e d by:

a linkage having an input connected to the mechanism and an output shaft (24) connected to the encoder (32,34) so that movement of the mechanism over its range of motion produces multiple rotations of said output shaft;

angular motion sensing means (32), coupled to said output shaft (24), for producing a first signal indicating the angular rotation of the shaft;

a plurality of rotating members (44,46;74,76,78), each containing at least one index mark (48,50;80, 82,84) for identifying particular angular orientations of said rotating members;

sensing means (52,54;86,88,90) responsive to said index marks, for producing second signals indicating said particular angular orientations of said rotating members;

mechanical coupling means (42;72) for driving said rotating members (44,46;74,76,78) from said output shaft (24) so that the angular positions of said index marks (48,50;82,84) on each said member precess with respect to the angular positions of said index marks on the other said members as said output shaft (24) rotates; and processing means (60) responsive to said first and second signals for determining the angular displacements of said index marks (48,50;82,84) on each said member (44,46;74,76,78) with respect to said index marks on the other said members, and for determining from said angular displacements and from said first signals the absolute position of said mechanism.

2. The encoder as in claim 1, c h a r a c t e r i z e d in that the angular motion sensing means and one of the rotating members comprise an incremental digital encoder (32).

3. The encoder as in claim 2, c h a r a c t e r i z e d in that the incremental digital encoder (32) is attached directly to said output shaft (24).

4. A position encoder as in one of the preceding claims, c h a r a c t e r i z e d in that the mechanism is the output of a motor-driven actuator (14), where multiple rotations of the motor drive shaft (24) are required to move said output over its range of motion.

5. A position encoder as in one of claims 1 to 4, c h a r a c t e r i z e d in that the mechanism is driven by a servo-controlled motor (20), that said incremental encoder (32) comprises means for producing first signals indicating the incremental angular rotation of the drive motor shaft (24), and for producing an index pulse at a certain point once each rotation of said drive motor shaft; that said rotating members (44,46) form part of a discrete encoder (34), that a first one (44) of said rotating members is driven at a first predetermined ratio of the angular velocity of said drive motor shaft (24), and produces a first mark pulse at a certain point once each revolution, that a second one (46) of said rotating members is driven at a second predetermined ratio of the angular velocity of said motor drive shaft (24), and produces a second mark pulse at a certain point once each revolution; and that a processor (60) responsive to said first signals, to said index pulse and to said first and second mark pulses is provided, for determining the angular displacements of said first rotating member (44) and said second rotating member (46) with respect to said drive motor shaft (24), and for determining from said angular displacements and from said first pulse stream the absolute angular position of said servo-controlled member (14).

6. The apparatus as in claim 5, c h a r a c t e r i z- e d  in that the first rotating member and the second rotating member are idler gears (44,46) driven by a third gear (42) mounted on the drive motor shaft (24).

7. The apparatus as in claim 6, c h a r a c t e- r i z e d  in that the number of gear teeth of said third gear (42) is T1 and that the numbers of gear teeth of said idler gears (44,46) are T2 and T3, where T1 > T2, T1 > T3, and T2 does not equal T3.

8. The apparatus as in one of claims 5 to 7, c h a- r a c t e r i z e d  in that the discrete encoder (34) further comprises a housing (40) in which the first and second rotating members (44,46) are mounted, each of said rotating members having an aperture (48,50) in its periphery, and first and second detectors (52,54) mounted on said housing in fixed positions over the periphery of the first and second rotating members to detect the passage of said apertures, said first detector (52) producing said first mark pulse and said second detector (54) producing said second mark pulse upon detecting said apertures (48,50).

9. A method for determining the absolute position of a servo-controlled mechanism, c h a r a c-t e r i z e d  by the steps of:

driving a set of rotating members (42,44,46;72,74, 76,78) whose angular rotations precess with respect to each other so that the relative angular displacements of said rotating members with respect to one another are unique for each motor revolution in the range of motor revolutions which span the range of motion of the servo-controlled member (14);

measuring the angular displacement of said rotating members (42,44,46;72,74,76,78) with respect to each other at the present position of the servo-controlled member (14);

determining the motor revolution position represented by the combination of said angular displacements;

measuring the incremental position of said servo-controlled member (14) on the present motor revolution;

combining the motor revolution position and the incremental position to determine the absolute position of said servo-controlled mechanism (14).

1/5

FIG 1

FIG 2

0 201 106

FIG 3

0 201 106

FIG 4

**FIG 5**

NEGATIVE PHYSICAL LIMIT

PHYSICAL ZERO

POSITIVE PHYSICAL LIMIT

−M −M+1 −2 −1 ∅ 1 2 3 M−1 M

103 104 101 MOTOR REV.2 105 102

**FIG 6**

104 ∅ 101 1 2 3 4 5

$\theta$

106

$\theta_{OFF1}$

$T_{OFF1}$

$\theta_{R1}$

$\theta_{M1}$

(REV.3)

0 201 106